# EUROPEAN PATENT SPECIFICATION

(11) **EP 2 283 502 B1**
(45) Date of publication and mention of the grant of the patent: **03.08.2016**
(21) Application number: 09757960.1
(22) Date of filing: 01.06.2009
(51) Int. Cl.: H01H 13/83, H03K 17/96

(54) **AN ELECTRONIC DEVICE**
EIN ELEKTRONISCHES GERÄT
DISPOSITIF ELECTRONIQUE

(30) Priority: 05.06.2008 TR 200804104
(43) Date of publication of application: 16.02.2011
(73) Proprietor: Arçelik Anonim Sirketi, 34445 Istanbul (TR)
(72) Inventor: BERKAY, Cengiz, 34445 Istanbul (TR); OSMAN, Osman, 34445 Istanbul (TR)
(86) International application number: PCT/IB2009/052295
(87) International publication number: WO 2009/147610

(56) References cited:
- EP-A- 1 542 363
- EP-A- 2 048 780
- DE-C1- 4 208 922
- US-A1- 2005 133 351

## Description

### Field of the Invention

The present invention relates to an electronic device comprising a control panel.

### Prior Art

In the consumer electronics (television, receiver, DVD player, camera, etc), there are control panels comprising switches used for controlling some of the functions (channel selection, volume control, on-off) on the front panel of the device.

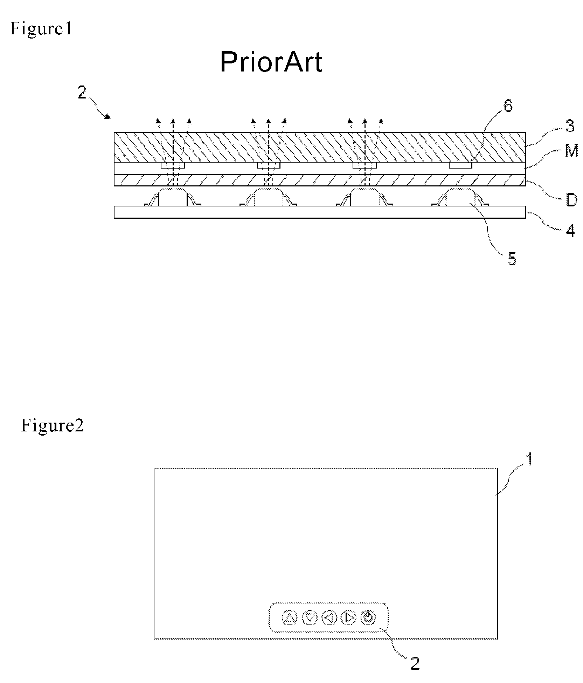

Places and functions of the switches on the device are made more distinct by means of the illuminated designs of the control panel. Illuminated switches are commonly used in the devices in which especially capacitive sensing switches are used instead of tact switches. Illumination of the said control panel is realized by a light emitted from a light emitting element placed behind the switches (inside of the device). In these embodiments in which light emitting diodes (LED) are generally used as a light emitting element, a printed circuit board is founded at the bottom of the control panel structure and LEDs are mounted on the printed circuit board. There are at least two layers, a mask (M) and a diffuser (D), between the LED and switch. There are icons formed by various methods such as embossing or engraving, and indicating function of the switch on the mask layer (M). The diffuser (D) enables illumination of the push button uniformly by diffusing the light emitted from the light emitting element. (Figure 1)

In JP6076684, an application within the state of the art, a switch illumination structure is disclosed. Light emitted from the light source placed on the circuit board is transmitted through the coloured and transparent layers, thereby providing backlight for the switch.

In JP2005243322, an application within the state of the art, an embodiment in which the switch is illuminated from the behind is disclosed. Light emitting element (LED) is arranged on the bottom surface of a printed circuit board, and illumination of the switch is realized by reflecting the lights at the inclination part. Further, US 2005/0133351 A1 discloses a non-movable switch comprising an illuminated control panel having a semitransparent front panel; at least one circuit board placed behind the front panel, made of a transparent material, covered with a conductive material and at least one light emitting element mounted on the bottom surface of the circuit board.

### Summary of the Invention

The objective of the present invention is to realize an electronic device facilitating the manufacture and inexpensive.

Another objective of the invention is to realize an electronic device in which thickness of the control panel is reduced and which takes a smaller place.

The electronic device realized to fulfill the objective of the present invention and defined in Claim 1 and its dependent claims, comprises a control panel. There are icons formed by engraving the conductive material covering the circuit board into geometric figures and indicating the functions of the switches, and the light emitting elements placed on the bottom surface of the board emit lights toward board. Light emitted from the light emitting element passes through the icon areas on the board so as to form icon images on the front panel of the device. During this passage, the light is diffused and thereby illumination of the control panel is realized uniformly. With this invention, there is no need to use any further mask and diffuser other than the circuit board.

### Detailed Description of the Invention

The electronic device realized to fulfill the objective of the present invention is illustrated in the accompanying figures wherein,
Figure 1 is a sectional view of a control panel. (Prior art)
Figure 2 is a schematic view of the inventive electronic device.
Figure 3 is a view of circuit board on which functional icons are engraved.
Figure 4 is a sectional view of the inventive control panel.

The components shown in the figures are numbered individually, where the numbers refer to the following:
1. Electronic device
2. Control panel
3. Front panel
4. Circuit board
5. Light emitting element
6. Icon

The inventive electronic device (1) comprises a control panel (2) on which switches used for controlling the electronic device (1) are found. (Figure 2)

Control panel (2) comprises a semitransparent front panel (3); at least one circuit board (4) placed behind the front panel (3), made of a semitransparent material, covered with a conductive material; at least one light emitting element (5) mounted on the bottom surface of the circuit board (4) and at least one icon (6) formed by engraving the conductive material covering the board (4) into geometric figures and indicating the functions of the switches.

Front panel (3) which is the top layer of the control panel (2) is the part visible from the outside of the electronic device (1). Light emitted from the light emitting element (5) passes through the icons (6) formed by engraving the cover on the circuit board, and transmitting the light as the circuit board is made of semitransparent material, and forms icon (6) images on the front panel (3). Images of the icons (6) can be seen from the outside as the front panel (3) is semitransparent.

Circuit board (4) is the board on which the electronic components and conductive lines between these components are fixed. In the control panel (2), light emitting elements (5) used as light source are fixed on the bottom surface of the board (4) so as to transmit the lights to the board (4). Light emitting diodes (LEDs) are preferably used as light emitting elements (5).

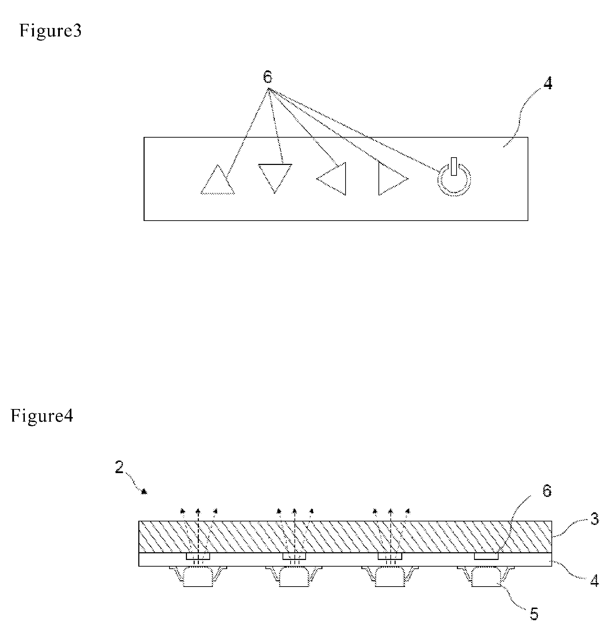

Board (4) is preferably made of glass fibre. In general, copper is used as conductive material allowing connections between the components. Icons (6) indicating the functions of the switches are formed on the circuit board (4) by engraving the copper layer at the desired points into the desired geometric figures (Figure 3). At the points where the copper is engraved, glass fibre material formed the board (4) transmits the light emitted from the light emitting element (5), whereby icon images are formed on the front panel (3).

In the inventive electronic device (1), illumination of the control panel (2) is realized as follows: the light emitted from the light emitting elements (5) fixed on the bottom surface of the board (4) on a level with the icon (6) such as to be preferably one for each icon (6) passes firstly through the parts of the board (4) engraved into icon (6) images. During this passage, light is diffused as the board (4) is made of glass fibre. Once the light diffused as proceeding and passing through the icon (6) parts reaches to the front panel (3), uniformly illuminated icon images indicating the function of each switch are formed on the front panel (3). (Figure 4)

In the control panel (2) structure used in the inventive electronic device (1) and described above, there is no need to use any further mask (M) and diffuser (D) layer as the icons (6) are formed on the circuit board (4) and the light emitted from the light emitting element (5) is diffused while passing through the board (4). By using only the board (4) such as to serve both as mask and diffuser layers, the electronic device having control panel (2) gets a more compact structure.

## Claims

1. An electronic device (1) comprising a illuminated control panel (2) having a semitransparent front panel (3); at least one circuit board (4) placed behind the front panel (3), made of a semitransparent material, covered with a conductive material and at least one light emitting element (5) mounted on the bottom surface of the circuit board (4); said control panel (2) having at least one icon (6) formed by engraving the conductive material covering the board (4) into geometric figures and indicating functions of switches.

2. An electronic device (1) according to Claim 1, **characterized by** light emitting elements (5) mounted on the bottom surface of the circuit board (4) such as to be on a level with the each icon (6) such as to be preferably one for each icon.

3. An electronic device (1) according to any one of the claims, **characterized by** a board (4) serving as diffuser by enabling diffusion of the lights emitted from the light emitting element (5) during the passage of the said lights as the area where the conductive material is engraved while the icons (6) are formed is semitransparent, and allowing illumination of the front panel (3) uniformly.

4. An electronic device (1) according to any one of the claims, **characterized by** a front panel (3) on the front surface of which illuminated icon images indicating function of each switch are formed when the lights emitted from the light emitting elements (5) are passed through the icons (6) and the front panel (3).

## Patentansprüche

1. Elektronische Vorrichtung (1), **umfassend** eine beleuchtete Steuerkonsole (2) mit einer halbtransparenten Vorderverkleidung (3); wenigstens eine Platine (4), die hinter der Vorderverkleidung (3) angebracht ist, aus einem halbtransparenten Material hergestellt ist, mit einem leitfähigen Material bedeckt ist und wenigstens ein Leuchtelement (5) aufweist, das an der Unterseite der Platine (4) angebracht ist; **dadurch gekennzeichnet, dass** die Steuerkonsole (2) wenigstens ein Symbol (6) aufweist, das durch Gravieren des leitfähigen Materials, welches die Platine (4) bedeckt, zu geometrischen Figuren gebildet wird und Funktionen von Schaltern angibt.

2. Elektronische Vorrichtung (1) nach Anspruch 1, **dadurch gekennzeichnet, dass** Leuchtelemente (5) derart an der Unterseite der Platine (4) angebracht sind, dass sie auf einer Höhe mit jedem Symbol sind (6), derart, dass vorzugsweise wenigstens eins für jedes Symbol vorliegt.

3. Elektronische Vorrichtung (1) nach einem der vorangehenden Ansprüche, **gekennzeichnet durch** eine Platine (4), die als eine Streueinrichtung dient, indem sie das Streuen der von dem Leuchtelement (5) abgestrahlten Lichter während des Hindurchtretens der Lichter ermöglicht, da die Fläche, wo das leitfähige Material beim Bilden der Symbole (6) graviert ist, halbtransparent ist, und die ein gleichmäßiges Beleuchten der Vorderverkleidung (3) ermöglicht.

4. Elektronische Vorrichtung (1) nach einem der vorangehenden Ansprüche, **gekennzeichnet durch** eine Vordemerkleidung (3), an deren Vorderfläche beleuchtete Symbolbilder gebildet sind, die die Funktion der einzelnen Schalter angeben, wenn die von den Leuchtelementen (5) abgestrahlten Lichter **durch** die Symbole (6) und die Vorderverkleidung (3) treten.

## Revendications

1. Un dispositif électronique (1) comprenant un panneau de command illuminé (2) présentant un panneau avant semi-transparent (3) ; au moins une carte de circuit (4) qui est placé derrière le panneau avant (3), qui est produit d'un matériau semi-transparent et qui est recouvert avec un matériau conducteur et au moins un élément émetteur de lumière (5) qui est monté sur la surface de fond de la carte de circuit (4) ; **caractérisé par** ledit panneau de commande (2) qui présente au moins une icône (6) qui est formée en gravant le matériau conducteur recouvrant la carte (4) en figures géométriques et qui indique les fonctions des commutateurs.

2. Un dispositif électronique (1) selon la Revendication 1, **caractérisé par** des éléments émetteurs de lumière (5) qui sont montés sur la surface de fond de la carte de circuit (4) de manière à être au niveau de chaque icône (6), préférablement un pour chaque icône.

3. Un dispositif électronique (1) selon l'une quelconque des revendications précédentes, **caractérisé par** une carte (4) qui sert d'un diffuseur en permettant la diffusion des lumières émise par l'élément émetteur de lumière (5) pendant le passage desdites lumières comme le zone où le matériau conducteur est engravé lorsque les icônes (6) sont formées est semi-transparent, et permettant l'illumination uniforme du panneau avant (3).

4. Un dispositif électronique (1) selon l'une quelconque des revendications précédentes, **caractérisé par** un panneau avant (3) sur la surface avant duquel des images d'icônes illuminées indiquant la fonction de chaque commutateur sont formées lorsque les lumières émises par les éléments émetteurs de lumière (5) passent à travers les icônes (6) et le panneau avant (3).
